# EUROPÄISCHE PATENTSCHRIFT

(11) **EP 2 626 445 B1**
(45) Veröffentlichungstag und Bekanntmachung des Hinweises auf die Patenterteilung: **24.02.2016**
(21) Anmeldenummer: 12195198.2
(22) Anmeldetag: 03.12.2012
(51) Int. Cl.: C23C 16/04, C23C 16/455, C23C 16/509, H01J 37/32

(54) **Hohlkathoden-Gaslanze für die Innenbeschichtung von Behältern**
Hollow cathode gas lance for internally coating containers
Lance à gaz à cathodes creuses pour le revêtement interne de récipients

(30) Priorität: 09.02.2012 DE 102012201956
(43) Veröffentlichungstag der Anmeldung: 14.08.2013
(73) Patentinhaber: Krones AG, 93073 Neutraubling (DE)
(72) Erfinder: Krüger, Jochen, 93073 Neutraubling (DE)
(74) Vertreter: Grünecker Patent- und Rechtsanwälte PartG mbB

(56) Entgegenhaltungen:
- DE-A1- 19 726 443
- US-A- 5 716 500
- US-B1- 6 376 028
- US-B1- 6 528 947

## Beschreibung

### Stand der Technik

Zur Verminderung der Durchlässigkeit von Behälter-/Hohlkörperwänden, z.B. in Bezug auf unerwünschte Stoffe, ist es vorteilhaft, diese mit einer Barriereschicht zu versehen, beispielsweise durch plasmaunterstützte chemische Gasphasenabscheidung / Plasma Enhanced Chemical Vapor Depositon (PECVD), wie z.B. in der EP0881197A2 beschrieben.

Zur Beschichtung von Behältnissen mittels Plasmabehandlung, beispielsweise der Plasma-Innenbeschichtung von Kunststoffflaschen, kann unter anderem ein sogenanntes Hochfrequenzplasma eingesetzt werden.

Hierbei wird z.B. ein Plasma in einem Behälter erzeugt, indem das Innere des Behälters auf einen Druck im Bereich von 1-10 Pa evakuiert und einem Hochfrequenzfeld ausgesetzt wird. Durch eine Gaslanze kann ein Gasgemisch, beispielsweise aus einem Silizium-Monomer und Sauerstoff in das Innere des Behälters eingebracht werden. Durch diesen Gasstrom kann sich der Druck in dem Behälter um einige 10 Pa erhöhen und so im Bereich von 10 - 30 Pa oder darüber liegen.

Dabei kann sich außerhalb des Behälters eine flächige Elektrode befinden, die mit Hochfrequenz beschickt werden kann, beispielsweise mit 13,56 MHz. Die Gaslanze, die gleichzeitig auch Elektrode sein kann, besteht in der Regel aus Metall und ist über eine Verbindung mit dem Maschinengehäuse geerdet, wie beispielsweise in der WO2009026869 beschrieben.

Die US6528947 B1 beschreibt ebenfalls eine Gaslanze, die als Hohlkathode wirt.

Die Hochfrequenz koppelt dabei an die Gaslanze an und es kann ein Plasma im Inneren des Behälters gezündet werden. Durch mehrere geeignet positionierte Bohrungen in der Gaslanze kann das Prozessgas in dem Behälter gleichmäßig verteilt und der Behälter innen gleichmäßig beschichtet werden.

Diese Art der Hochfrequenzeinkopplung ist jedoch ungeeignet dafür, große Flächen wie zum Beispiel die Innenseite von Flaschen mit hohen Abscheideraten von mehr als >2 nm/s zu beschichten, da hierzu ein hoher Gasstrom und damit verbunden auch eine hohe elektrische Leistung in Form von Hochfrequenz benötigt wird. Darüber hinaus haben Plasmen, die mit Hochfrequenz angeregt werden, in der Regel eine geringere Plasmadichte, als Plasmen, die z.B. mit Mikrowellen angeregt werden. Dies kann sich ebenfalls nachteillig auf die Dauer und Effizienz des Beschichtungsverfahrens auswirken.

### Aufgabe

Es ist somit Aufgabe der Erfindung eine Vorrichtung zur Beschichtung von Behältern mittels Plasmabehandlung, beispielsweise der plasmaunterstützten Beschichtung von Kunststoffflaschen, zu verbessern, insbesondere hinsichtlich Leistung und Effizienz.

### Lösung

Dies wird erfindungsgemäß durch eine Vorrichtung nach Anspruch 1 und einem Verfahren nach Anspruch 8 erreicht. Vorteilhafte Ausführungsformen und Weiterbildungen sind Gegenstand der Unteransprüche.

Eine Vorrichtung zur Beschichtung eines Behälters, beispielsweise einer Kunststoffflasche, mittels Plasmabehandlung, kann dabei wenigstens eine Hochfrequenzquelle, wenigstens eine sich außerhalb des zu behandelnden Behälters befindliche Außenelektrode, sowie wenigstens eine mindestens teilweise elektrisch leitende Gaslanze zum Zuführen von Prozessgas in den Behälter beinhalten. Die von der Hochfrequenzquelle erzeugte Hochfrequenz kann dabei wahlweise auf die wenigstens eine Außenelektrode oder die wenigstens eine Gaslanze beaufschlagt werden. Die Gaslanze kann sich dadurch auszeichnen, dass sie mindestens teilweise oder vollständig als Hohlkathode mit wenigstens einem inneren Hohlraum ausgeführt sein kann, wobei der wenigstens eine Hohlraum der Hohlkathode strömungstechnisch mit dem Inneren des zu behandelnden Behälters sowie mit dem prozessgaszuführenden Teil der Gaslanze verbunden sein kann, durch seitliche und axiale Bohrungen oder Aussparungen, und im Inneren der Hohlkathode im wenigstens einen Hohlraum ein Plasma erzeugt werden kann. Nach dem Zünden des Plasmas kann sich um die Gaslanze herum eine Plasmarandschicht ausbilden, welche vorteilhafterweise über besagte strömungstechnische Verbindung vom Inneren des Behälters zum wenigstens einen Hohlraum der Hohikathode über eine Öffnung oder Aussparung in der Gaslanze in die Hohlkathode/den Hohlkathodenhohlraum eindringen kann. Im Inneren der Hohlkathode können sich die Plasmarandschichten gegenüberliegender Wandungen überlagern, was zu Pendelbewegungen der Elektronen führen kann. Die Elektronen können dabei sehr viel Energie aufnehmen und es kann sich vorteilhafterweise ein sehr intensives Plasma bilden, mit dem der Behälter schneller und effektiver beschichtet werden kann. Die Plasmadichte im Inneren der Hohlkathode kann dabei um 1-2 Größenordnungen über der Plasmadichte im rein kapazitiv gekoppelten Plasma außerhalb der Hohlkathode liegen, was die Umsetzung des Gasgemisches begünstigt.

Durch die beschriebene erfindungsgemäße Anordnung kann die Effizienz der Prozessgasumsetzung, d.h. z.B. die Zerlegung von Hexamethyldisiloxan (HMDSO) deutlich verbessert werden, was sich darin äußert, dass in die erzeugte Beschichtung deutlich weniger CH₃ eingebaut wird. CH₃ ist im HMDSO-Molekül enthalten und wird bei dessen Dissoziation vom Silizium abgespalten. Bei unvollständiger Dissoziation bzw. Zersetzung von HMDSO wird diese Methyl-gruppe in die Schicht eingebaut, was zu weicheren Beschichtungen führen kann, die eine deutlich schwächere Barrierewirkung aufweisen können.

Die höhere Plasmadichte, die von einer erfindungsgemäßen Vorrichtung im Vergleich zu plasmaunterstützten Vorrichtungen zur Behälterbeschichtung in Hochfrequenzfeldern ohne Hohlkathodenplasmaerzeugung erreicht werden kann, kann somit vorteilhafterweise den Grad der Dissoziation von HMDSO verbessern und somit auch die Güte der Beschichtung, bzw. deren Barrierewirkung.

Der nicht als Hohlkathode ausgeführte Teil der Gaslanze kann dabei Bohrungen oder Aussparungen, bevorzugt seitlich und/oder axial angebracht, beispielsweise mit mittleren Bohrungs- oder Aussparungsdurchmessern > 0.5 mm, bevorzugt 1 - 2 mm, aufweisen, durch die Prozessgas, z.B. ein Sauerstoff-Monomer-Gemisch, in das Innere des Behälters und/oder in den wenigstens einen Hohlraum der Hohlkathode zugeführt werden kann.

Vorteilhafterweise kann die Gaslanze dabei auf Ihrer gesamten Länge, beispielsweise 50 - 500 mm, bevorzugt 200-300 mm, einen Innen-Hohlraum aufweisen, beispielsweise mit mittlerem Innendurchmesser 2 - 20 mm, bevorzugt 6 mm, und der Innen-Hohlaum mit Bohrungen oder Aussparungen, bevorzugt seitlich und/oder axial angebracht, beispielsweise mit mittleren Bohrungs- oder Aussparungsdurchmessern > 0.5 mm, bevorzugt 1 - 2 mm, versehen sein. Dies hat den Vorteil, dass über die gesamte Länge der Gaslanze ein Plasma im Inneren der Gaslanze, d.h. im Innenhohlraum, erzeugt werden kann, welches ebenso über die gesamte Länge der Gaslanze durch besagte Bohrungen bzw. Aussparungen austreten kann, um so den Behälter effektiver beschichten zu können.

Zusätzlich kann die Gaslanze drehbar montiert sein, so dass nach Erzeugung des Plasmas im Inneren der Gaslanze, das Plasma gleichmäßiger und schneller im Behälter verteilt werden kann, um so eine gleichmäßigere Beschichtung erreichen zu können.

Die Dimensionierung einer Hohlkathode, bzw. des Innen-Hohlraums, ergibt sich in erster Näherung aus der Zündbedingung für ein Plasma nach der Paschenkurve, welche die Durchschlagspannung V als Funktion des Produktes aus Druck p und Elektrodenabstand d angibt: V=*f*(p*d). Ideale Zündbedingungen herrschen dabei im Bereich p*d =1 - 10 hPa*cm.

Daraus ergibt sich beispielhaft, dass bei einem Druck von 100 Pa der ideale Innendurchmesser einer Hohlkathode, bzw. des Innen-Hohlraums, im Bereich von 1 cm ≦ d ≦ 10 cm liegt. Bei plasmaunterstützten Beschichtungsverfahren mit Hochfrequenz liegt der Druck im Behälter wie bereits erwähnt in der Regel jedoch bei etwa 10-30 Pa, woraus folgt, dass die Hohlkathode einen Innendurchmesser von einigen Zentimeter haben sollte. Es kann unter Umständen jedoch unpraktisch oder sogar technisch nicht möglich sein, so dimensionierte Hohlkathoden in einen Behälter einzuführen. Zur Realisierung von kleineren Hohlkathoden-Innendurchmessern, z.B. mit d ≦ 1 cm muss der Druck im Bereich der Hohlkathode entsprechend erhöht werden, beispielsweise indem ein Gas in die Hohlkathode einströmt. Dies wird erfindungsgemäß dadurch erreicht, dass die Hohlkathode, bzw. der Innen-Hohlraum, strömungstechnisch mit dem prozessgaszuführenden Teil der Gaslanze verbunden sein kann, so dass einströmendes Prozessgas den Druck im Bereich der Hohlkathode / des Innen-Hohlraums erhöhen kann, beispielsweise auf Drücke ≧ 100 oder 200 Pa.

Für eine mögliche Beschichtung des Behälters mit Siliziumoxyd kann z.B. als Prozessgas ein Gemisch aus HMDSO und Sauerstoff verwendet werden, prinzipiell eignen sich aber auch Gemische aus Sauerstoff und anderen siliziumhaltigen Monomeren. Es können aber auch kohlenstoffhaltige Schichten abgeschieden werden (sogenannte Diamond Like Carbon "DLC"-Schichten), indem ein kohlenstoffhaltiges Gas, wie z.B. Acetylen, Methan, etc. im Plasma zersetzt wird.

Das zersetzte Prozessgas kann die Hohlkathode strömungsbedingt verlassen und sich im Behälter verteilen, wo die entsprechend erzeugten Partikel an der Behälterwand abgeschieden werden können.

Es ist ferner denkbar, dass anstatt einem Prozessgas, ein neutrales nichtbeschichtendes Inertgas wie z.B. Argon, oder beispielsweise ein Gemisch aus Sauerstoff und Argon, in die Hohlkathode, bzw. in den Innen-Hohlraum eingeleitet werden kann. Dies hat den Vorteil, dass eine unerwünschte Beschichtung des Inneren der Hohlkathode minimiert werden kann. In diesem Fall kann ein im Außenbereich der Hohlkathode brennendes Prozessgasplasma von einem Hohlkathodenplasma, welches aus einem neutralen nichtbeschichtenden Inertgas erzeugt wurde, "gefüttert" werden. Hierzu kann die Gaslanze so ausgebildet sein, dass Prozessgas und neutrales nichtbeschichtendes Inertgas, räumlich getrennt zugeführt werden können, wobei das Prozessgas direkt dem Behälter, und das neutrale nichtbeschichtende Inertgas direkt der Hohlkathode, bzw. dem Innen-Hohlraum, zugeführt werden kann.

Wie eingangs erwähnt, kann ein Hohlkathodenplasma sehr intensiv sein und eine hohe Plasmadichte aufweisen, welche z.B. um einen Faktor 10 bis 100 höher als bei einem rein kapazitiv gekoppelten Plasma sein kann. Das Plasma, das dann aus der Hohlkathode heraus in die Flasche einströmt, weist einen hohen Anteil an geladenen Teilchen und Radikalen auf. Mischt sich dieses reaktive Plasma außerhalb der Hohlkathode mit dem Prozessgasplasma bzw. dem Prozessgas, so kann letzteres effizienter zersetzt werden, und eine effizientere Schichtbildung auf der Behälterwand erreicht werden.

Beigefügte Figuren stellen beispielhaft dar:
- Fig. 1:: Behälterbeschichtungsvorrichtung.
- Fig. 2a:: Gaslanze.
- Fig. 2b:: Gaslanze.
- Fig. 3:: Gaslanze.
- Fig. 4:: Gaslanze.
- Fig. 5:: Gaslanze.

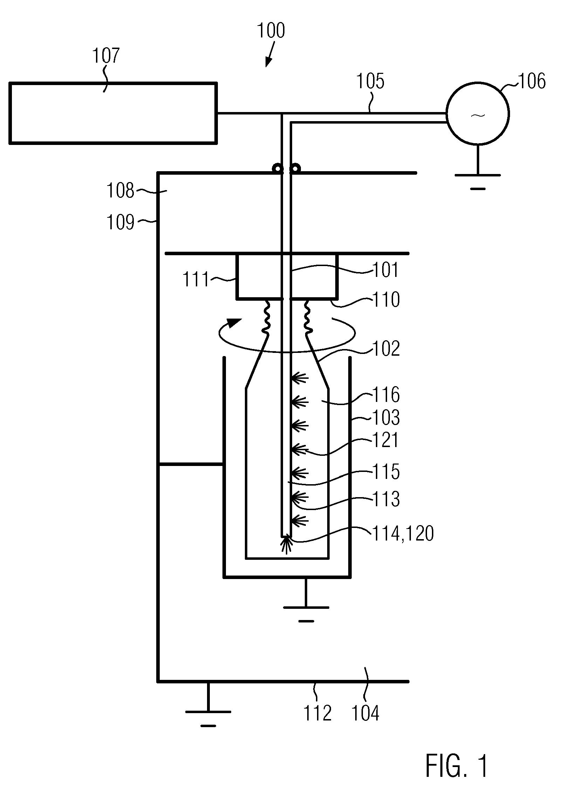

In Fig.1 ist beispielhaft eine Vorrichtung 100 zur plasmaunterstützten Beschichtung eines Behälters 102 dargestellt. Dabei kann die Vorrichtung 100 zwei verschiedene Druckbereiche aufweisen, beispielsweise eine Grund-Druckkammer 104, welche z.B. auf Drücke von 100 bis 4000 Pa evakuiert werden kann, und beispielsweise eine Prozess-Druckkammer 108, in welcher z.B. Drücke zwischen 1 bis 30 Pa herrschen können. Eine Hochfrequenzquelle 107 kann über eine Leitung 105 Hochfrequenz in eine Gaslanze 101 einspeisen. Die Leitung 105 kann zusätzlich ebenso dazu dienen Gas von einer Gasquelle 107 der Gaslanze 101 zuzuführen.

Die Grund-Druckkammer 104 kann über eine Außenelektrode 103 verfügen, z.B. in U-Form, die den zu behandelnden Behälter 102 mindestens teilweise umfassen kann, ohne den Behälter 102 zu berühren, da der Behälter 102 beispielsweise über eine Flaschenklammer 110 aufgehängt sein kann. Die Außenelektrode 103 kann beispielsweise elektrisch mit einem Teil des Grund-Druckkammergehäuses 112 verbunden sein, und kann darüber so z.B. geerdet sein. Nicht dargestellt aber möglich ist auch, dass wahlweise die Außenelektrode 103 eine Hochfrequenz von der Hochfrequenzquelle 106 abstrahlen kann, während die Gaslanze 101 geerdet sein kann, z.B. durch eine elektrische Verbindung mit Vorrichtungsgehäuseteilen oder Druckkammerteilen.

Die Aufhängung des Behälters 102 über eine Flaschenklammer 110 kann so gestaltet sein, dass der Behälter 102 gedreht werden kann, beispielsweise um seine Längsachse in Schwerkraftrichtung. Ebenso ist denkbar, dass die Gaslanze 101 gedreht werden kann, bevorzugt beispielsweise um deren Längsachse in Schwerkraftrichtung während der Beschichtungsbehandlung.

Die Gaslanze 101 ist beispielhaft auf Ihrer gesamten Länge als Hohlkathode ausgeführt und kann Bohrungen bzw. Aussparungen aufweisen, beispielsweise seitliche Bohrungen 113 und/ oder axiale Bohrungen 114, mit Bohrungsdurchmessern > 0.5 mm, bevorzugt 1 - 2 mm. Die Hohlkathodenaustrittsöffnung 120 am Ende der Gaslanze 101, kann aber auch nur eine einzelne einfache Öffnung sein, oder eine gitterartige Struktur aufweisen. Durch die Bohrungen 113, 114 kann Prozessgas in den Behälter 102 eingelassen werden. Ebenso kann sich ein erzeugtes Hohlkathodenplasma 115 aus dem Inneren der Gaslanze 101, bzw. dem Inneren der Hohlkathode, durch die Bohrungen / Aussparungen 113, 114 ins Innere des Behälters 102 ausbreiten und ein eventuell bereits vorhandenes Prozessgasplasma 116 im Inneren des Behälters 102 unterstützen und verstärken, bzw. das Prozessgas zünden, zur effektiveren Umsetzung des Prozessgases und Abscheidung einer Beschichtung auf der Innenwand des Behälters 102.

Die Vorrichtung der Fig.1 kann beispielsweise als Karussell verwirklicht werden, bei dem die Behälter 102 auf einer Kreissegmentbahn geführt werden können, während sie durch den Bereich der Plasmabehandlung laufen.

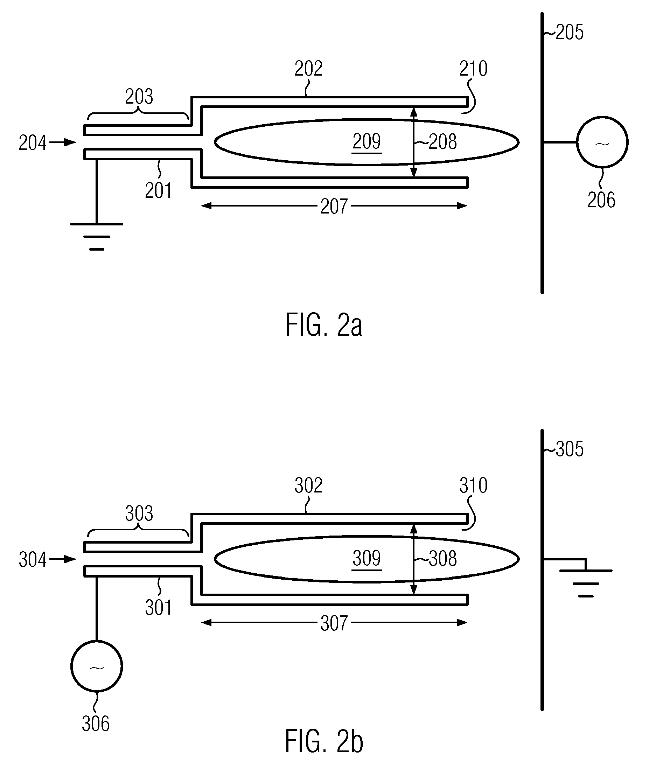

In Fig. 2a ist beispielhaft der nicht erfinderische Grundaufbau einer Gaslanze 201 mit Hohlkathode 202 skizziert, bei dem über eine Außenelektrode 205 Hochfrequenz von einer Hochfrequenzquelle 206 abgestrahlt werden kann und an eine elektrisch leitende geerdete Gaslanze 201 ankoppeln kann. Die Gaslanze 201 kann an Ihrem Ende als Hohlkathode 202 ausgeführt sein, wobei die Länge 207 und Breite bzw. Innendurchmesser 208 des Innenhohlraums der Hohlkathode 202 vorteilhafterweise auf den in der Hohlkathode 202 herrschenden Druck abgestimmt sein können, damit ein Hohlkathodenplasma 209 leichter gezündet und aufrecht erhalten werden kann. Beispielsweise kann nach der bereits erwähnten Paschenkurvenrelation, der Hohlkathodeninnenhohlraum einen Innendurchmesser 208 zwischen 1 cm ≦ d ≦ 10 cm für einen Druck von 100 Pa, bzw. Innendurchmesser 208 < 1 cm für Drücke > 100 Pa, aufweisen, um die erforderliche Durchschlagsspannung zu minimieren.

Über den nicht als Hohlkathode ausgebildeten Teil 203 der Gaslanze 201 kann Gas, beispielsweise Prozessgas, dem Hohlkathodeninnenhohlraum zugeführt werden. Das Hohlkathodenplasma 209 kann beispielsweise über die Hohlkathodenaustrittsöffnung 210 austreten.

Der in Fig. 2b gezeigte beispielhafte nicht erfinderische Grundaufbau einer Gaslanze 301 mit Hohlkathode 302 ist identisch mit dem Aufbau aus Fig. 2a, bis auf die Tatsache, dass hier die Außenelektrode 305 geerdet sein kann und die Hochfrequenz der Hochfrequenzquelle 306 über die Gaslanze 301 abgestrahlt werden kann.

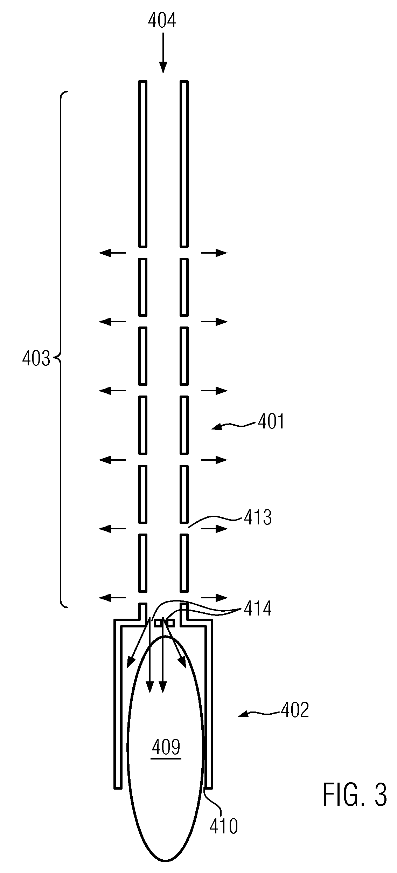

In Fig. 3 ist beispielhaft eine nicht erfinderische Gaslanze 401 dargestellt, deren Ende eine Hohlkathode 402 sein kann. Der nicht als Hohlkathode ausgeführte Teil 403 der Gaslanze, kann dabei seitliche 413 und/oder axiale 414 Bohrungen bzw. Aussparungen aufweisen, durch die Gas 404, z.B. Prozessgas, in das Innere des Behälters und in das Innere der Hohlkathode 402 zugeführt werden kann. Die mittleren Bohrungs- oder Aussparungsdurchmessern können bei > 0.5 mm, bevorzugt bei 1 - 2 mm liegen.

Es ist aber auch denkbar, dass mittlere Bohrungs- oder Aussparungsdurchmessern < 0.5 mm verwendet werden können, um eine Bildung bzw. Ausbreitung von Hohlkathodenplasma 409 innerhalb des nicht als Hohlkathode ausgeführten Teils 403 der Gaslanze 401 zu minimieren oder gar zu unterbinden, und den Austritt des Hohlkathodenplasmas 409 auf die Hohlkathodenaustrittsöffnung 410 beschränken zu können.

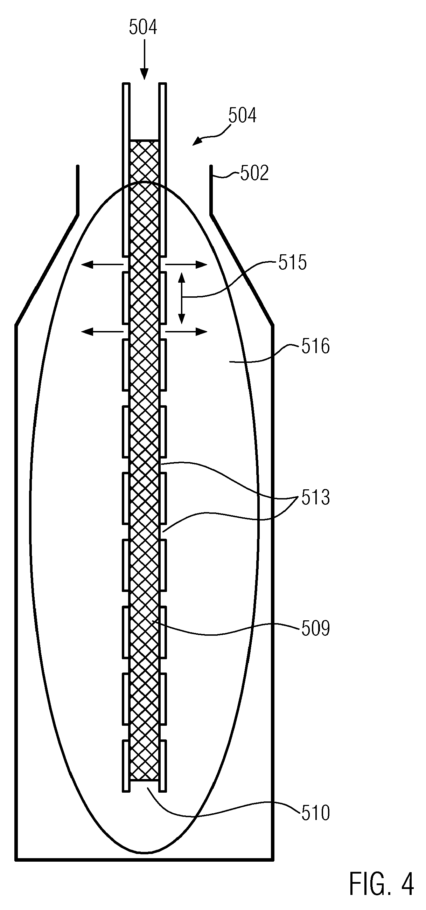

Die Fig.4 stellt beispielhaft eine Gaslanze 501 dar, die auf Ihrer gesamten Länge als Hohlkathode ausgeführt sein kann. Dabei kann die Gaslanze 501 Bohrungen / Aussparungen, bevorzugt seitliche Bohrungen 513, aufweisen, wobei die mittleren Bohrungs- oder Aussparungsdurchmesser bei > 0.5 mm, bevorzugt bei 1 - 2 mm liegen können. Die Abstände der Bohrungen können regelmäßig oder unregelmäßig sein, bevorzugt aber z.B. regelmäßig bei 20 mm liegen. Das Ende der Gaslanze 501, bzw. die Hohlkathodenaustrittsöffnung 510 kann wie dargestellt vollständig offen sein, oder aber über axiale Bohrungen / Aussparungen (nicht dargestellt), z.B. mit mittleren Bohrungs- oder Aussparungsdurchmessern > 0.5 mm, bevorzugt bei 1 - 2 mm verfügen.

Über die gesamte Länge der Gaslanze 501 kann Gas 504, z.B. Prozessgas, ins Innere der Gaslanze bzw. Hohlkathode zugeführt werden, und kann sich durch besagte Bohrungen / Aussparungen in das Innere des Behälters 502 verteilen.

Ein erzeugtes Hohlkathodenplasma 509 kann sich ebenso über die gesamte Länge der Gaslanze 501 in das Innere des Behälters 502 ausbreiten und sich so gegebenenfalls mit einem bereits vorhandenen Prozessgasplasma 516 vermischen, oder das Prozessgasplasma 516 zünden, um so den Behälter 502 effektiver beschichten zu können.

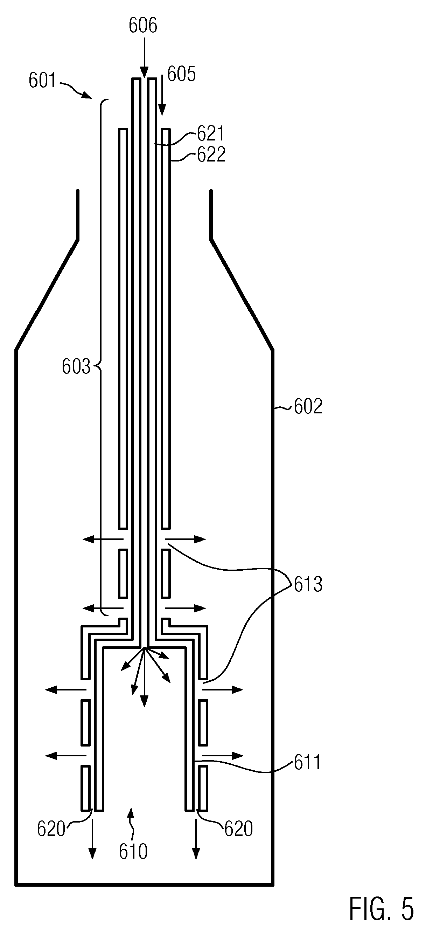

Die Fig. 5 stellt beispielhaft eine nicht erfinderische Gaslanze 601 dar, bei der ein Prozessgas 605 in das Innere des Behälters 602 geleitet werden und gleichzeitig und räumlich getrennt vom Prozessgas 605 ein neutrales nichtbeschichtendes Inertgas 606, wie z.B. Argon, oder ein Gemisch aus Sauerstoff und Argon, in das Innere der Hohlkathode / den Hohlkathodeninnenhohlraum 611 geleitet werden kann, um beispielsweise vorteilhafterweise den Druck im Inneren der Hohlkathode zu erhöhen zur Senkung der benötigten Durchschlagsspannung, sowie zur Minimierung unerwünschter Beschichtungen im Inneren der Hohlkathode und im Inneren der Gaslanze 601. Hierzu kann z.B. die Gaslanze 601 aus zwei ineinander liegenden Teilen bestehen. Über eine innere Gaslanze 621 kann z.B. besagtes neutrales nichtbeschichtendes Inertgas 606 in die Hohlkathode / den Hohlkathodeninnenhohlraum 611 der inneren Gaslanze 621 geführt werden. Erzeugtes Hohlkathodenplasma kann über die Hohlkathodenaustrittsöffnung 610 der inneren Gaslanze 621 in das Behälterinnere eintreten.

Gleichzeitig kann über eine äußere Gaslanze 622 dem Inneren des Behälters 602 Prozessgas 605, z.B. ein Gemisch aus HMDSO und Sauerstoff oder Gemische aus Sauerstoff und anderen Siliziumhaltigen Monomeren, zugeführt werden, in dem das Prozessgas 605 aus seitlichen Bohrungen / Aussparungen 613, beispielsweise mit mittleren Bohrungs- oder Aussparungsdurchmessern < 0.5 mm, bevorzugt 0.1 - 0.2 mm, um ein Plasmazünden im prozessgasführenden Teil der Gaslanze unterbinden zu können, und/oder aus wenigstens einer axialen Bohrung bzw. einer axialen Austrittsöffnung 620 der inneren Gaslanze, in das Behälterinnere austreten kann. Die äußere Gaslanze 622 kann dabei der Kontur der inneren Gaslanze 621 teilweise oder vollständig folgen, beispielsweise kann der Abstand zwischen innerer Gaslanze 621 und äußerer Gaslanze 622 konstant sein, bis z.B. auf eine Toleranz von 10, 20 oder 50 %.

Es folgen 5 Blatt mit 6 Figuren.

Die verwendeten Bezugszeichen sind dabei wie folgt belegt.
**100** Vorrichtung zur plasmaunterstüzten Beschichtung eines Behälters.
**101, 201, 301, 401, 501, 601** Gaslanze.
**102, 502, 602** Behälter.
**103, 205, 305** Außenelektrode.
**104** Grund-Druckkammer.
**105** Leitung
**112** Grund-Druckkammergehäuse.
**108** Prozess-Druckkammer.
**109** Prozess-Druckkammergehäuse.
**106, 206, 306** Hochfrequenzquelle.
**107** Gasquelle (für Prozessgas und/oder neutrales nichtbeschichtendes Inertgas).
**110** Flaschenklammer.
**111** Ventil.
**113, 413, 513, 613** Seitliche Bohrung / Aussparung / Öffnung.
**121** Aus Gaslanze bzw. Hohlkathode austretendes Plasma, z.B. als "Plasmatorch".
**114, 414** Axiale Bohrung / Aussparung / Öffnung.
**202, 302, 402,** Hohlkathode / Hohlkathodeninnenhohlraum.
**207, 307** Länge Hohlkathode.
**208, 308** Breite / Innendurchmesser Hohlkathode.
**203, 303, 403, 603** Teil der Gaslanze, welcher nicht als Hohlkathode ausgeführt ist.
**204, 304, 404, 504** Gas (z.B. Prozessgas, neutrales nichtbeschichtendes Inertgas, oder Kombination von Prozessgas und neutralem nichtbeschichtendem Inertgas).
**115, 209, 309, 409, 509** Hohlkathodenplasma.
**210, 310, 410, 510,120** Hohlkathodenaustrittsöffnung.
**515** Abstand zwischen Bohrungen / Aussparungen.
**116, 516** Prozessgasplasma.
**605** Prozessgas, z.B. Gemisch aus HMDSO und Sauerstoff, Gemische aus Sauerstoff und anderen Siliziumhaltigen Monomeren, oder Kohlenstoffhaltiges Gas, wie z.B. Acetylen, Methan, etc. zur Abscheidung Kohlenstoffhaltige Schichten, sogenannter Diamond Like Carbon "DLC"-Schichten.
**606** Neutrales nichtbeschichtendes Inertgas.
**621** Innere Gaslanze.
**622** Äußere Gaslanze.
**611** Hohlkathode / Hohlkathodeninnenhohlraum einer inneren Gaslanze.
**610** Hohlkathodenaustrittsöffnung einer inneren Gaslanze.
**620** Axiale Austrittsöffnung einer inneren Gaslanze.

## Patentansprüche

1. Vorrichtung (100) zur Beschichtung eines Behälters, beispielsweise einer Kunststoffflasche, mittels Plasmabehandlung, beinhaltend,
wenigstens eine Hochfrequenzquelle (106), wenigstens eine sich außerhalb des zu behandelnden Behälters (102) befindliche Außenelektrode (103), und wenigstens eine mindestens teilweise elektrisch leitende Gaslanze (101) zum Zuführen von Prozessgas in den Behälter (102), so konfiguriert, dass eine Hochfrequenz der Hochfrequenzquelle (106) auf die wenigstens eine Außenelektrode (103) oder die wenigstens eine Gaslanze (101) beaufschlagt werden kann, **dadurch gekennzeichnet, dass** die wenigstens eine Gaslanze (101) mindestens teilweise oder vollständig als Hohlkathode mit wenigstens einem inneren Hohlraum ausgeführt ist, wobei der wenigstens eine Hohlraum der Hohlkathode strömungstechnisch mit dem Inneren des zu behandelnden Behälters (102) sowie mit dem prozessgaszuführenden Teil der Gaslanze (101) verbunden ist, durch seitliche (113) und axiale Bohrungen oder Aussparungen (114), und im Inneren der Hohlkathode im wenigstens einen Hohlraum ein Plasma erzeugt werden kann.

2. Vorrichtung nach Anspruch 1, **dadurch gekennzeichnet, dass** der nicht als Hohlkathode ausgeführte Teil der Gaslanze mit Bohrungen oder Aussparungen, bevorzugt seitlich und/oder axial angebracht, beispielsweise mit mittleren Bohrungs- oder Aussparungsdurchmessern < 0.5 mm, bevorzugt 0.1 - 0.2 mm, versehen ist, durch die Prozessgas in das Innere des Behälters und/oder in den wenigstens einen Hohlraum der Hohlkathode zugeführt werden kann.

3. Vorrichtung nach Anspruch 1 oder 2, **dadurch gekennzeichnet, dass** die Gaslanze (101) auf Ihrer gesamten Länge, beispielsweise 50 - 500 mm, bevorzugt 200-300 mm, einen Innen-Hohlraum aufweist, beispielsweise mit mittlerem Innendurchmesser 2 - 20 mm, bevorzugt 6 mm, und der Innen-Hohlaum Bohrungen oder Aussparungen, bevorzugt seitlich (113) und/oder axial (114) angebracht, beispielsweise mit mittleren Bohrungs- oder Aussparungsdurchmessern > 0.5 mm, bevorzugt 1 - 2 mm, aufweist.

4. Vorrichtung nach einem der vorigen Ansprüche 1 bis 3, **dadurch gekennzeichnet, dass** die Gaslanze (101) drehbar montiert ist.

5. Vorrichtung nach einem der vorigen Ansprüche 1 bis 4, **dadurch gekennzeichnet, dass** die Gaslanze so ausgebildet ist, dass Prozessgas und neutrales nichtbeschichtendes Inertgas, räumlich getrennt zugeführt werden, wobei das Prozessgas direkt dem Behälter, und das neutrale nichtbeschichtende Inertgas direkt der Hohlkathode, bzw. dem Innen-Hohlraum, zugeführt werden.

6. Vorrichtung nach Anspruch 5, **dadurch gekennzeichnet, dass** die Gaslanze (601) über eine innere Gaslanze (621) verfügt, über die neutrales nichtbeschichtendes Inertgas (606) in den inneren Hohlraum der Hohlkathode (610) der inneren Gaslanze (621) zugeführt werden kann, sowie eine äußere Gaslanze (622) aufweist, durch die dem Inneren des Behälters (602) Prozessgas (605) zugeführt werden kann, in dem das Prozessgas (605) aus seitlichen Bohrungen / Aussparungen (613), beispielsweise mit mittleren Bohrungs- oder Aussparungsdurchmessern < 0.5 mm, bevorzugt 0.1 - 0.2 mm, und/oder aus wenigstens einer axialen Bohrung bzw. einer axialen Austrittsöffnung (620) der inneren Gaslanze (621), in das Behälterinnere austreten kann.

7. Vorrichtung nach Anspruch 6, **dadurch gekennzeichnet, dass** die äußere Gaslanze (622) der Kontur der inneren Gaslanze (621) teilweise oder vollständig folgt.

8. Verfahren zur plasmaunterstützten Beschichtung eines Behälters (102), welches beinhaltet, dass die Umsetzung eines Prozessgases von einem in einer Gaslanze (101) gemäß einem der vorherigen Ansprüche erzeugten Hohlkathodenplasma teilweise oder nahezu vollständig unterstützt wird.

## Claims

1. Apparatus (100) for coating a container, for instance a plastic bottle, by means of a plasma treatment, the apparatus comprising:
at least one high-frequency source (106), at least one outer electrode (103) located outside the container (102) to be treated, and at least one at least partially electrically conducting gas lance (101) for the supply of process gas into the container (102), configured to apply a high frequency of the high frequency source (106) to the at least one outer electrode (103) or the at least one gas lance (101), **characterized in that** the at least one gas lance (101) is configured at least in part or in whole as a hollow cathode having at least one internal hollow space, wherein the at least one hollow space of the hollow cathode is fluidically connected to the interior of the container (102) to be treated and to the part of the gas lance (101) that supplies the process gas by lateral (113) and axial bores or recesses (114), and that a plasma can be generated in the interior of the hollow cathode in the at least one hollow space.

2. Apparatus according to claim 1, **characterized in that** the part of the gas lance (101) that is not configured as a hollow cathode is provided with bores or recesses, which are preferably arranged on the side and/or axially, e.g. with average bore diameters or recess diameters < 0.5 mm, preferably 0.1-0.2 mm, through which process gas can be supplied into the interior of the container and/or into the at least one hollow space of the hollow cathode.

3. Apparatus according to claim 1 or 2, **characterized in that** the gas lance (101) comprises an internal hollow space, for instance, with an average internal diameter of 2-20 mm, preferably 6 mm, along the entire length of the gas lance, e.g. 50-500 mm, preferably 200-300 mm, and the internal hollow space is provided with bores or recesses, which are preferably arranged on the side (113) and/or axially (114), e.g. with average bore diameters or recess diameters > 0.5 mm, preferably 1-2 mm.

4. Apparatus according to one of the preceding claims 1 to 3, **characterized in that** the gas lance (101) is mounted rotatable.

5. Apparatus according to one of the preceding claims 1 to 4, **characterized in that** the gas lance is adapted to allow the physically separated supply of process gas and a neutral, non-coating inert gas, wherein the process gas can be supplied directly to the container and the neutral, non-coating inert gas can be supplied directly to the hollow cathode or the internal hollow space, respectively.

6. Apparatus according to claim 5, **characterized in that** the gas lance (601) comprises an inner gas lance (621) by means of which a neutral, non-coating inert gas (606) can be supplied into the internal hollow space of the hollow cathode (610) of the inner gas lance (621), and an outer gas lance (622) by means of which process gas (605) can be supplied into the interior of the container (602) by allowing the process gas (605) to flow out of lateral bores/recesses (613), for instance, with average bore diameters or recess diameters < 0.5 mm, preferably 0.1-0.2 mm, and/or out of at least one axial bore or axial outlet opening (620) of the inner gas lance (621) into the interior of the container.

7. Apparatus according to claim 6, **characterized in that** the outer gas lance (622) is adapted in part or in whole to the contour of the inner gas lance (621).

8. Method for the plasma-enhanced coating of a container (102), the method comprising that the conversion of a process gas is supported in part or nearly in whole by a hollow-cathode plasma generated in a gas lance (101) according to one of the preceding claims.

## Revendications

1. Dispositif (100) pour assurer le revêtement d'un récipient ou contenant, par exemple une bouteille plastique, au moyen d'un traitement par plasma, comprenant
au moins une source haute-fréquence (106), au moins une électrode extérieure (103) se trouvant à l'extérieur du contenant (102) à traiter, et au moins une lance à gaz (101) au moins partiellement conductrice sur le plan électrique, pour amener un gaz de processus dans le contenant (102), configurées de façon telle, qu'une haute fréquence de la source haute-fréquence (106) puisse être appliquée sur ladite au moins une électrode extérieure (103) ou ladite au moins une lance à gaz (101),
**caractérisé en ce que** ladite au moins une lance à gaz (101) est réalisée au moins partiellement ou en totalité en tant que cathode creuse avec au moins une cavité intérieure, ladite au moins une cavité intérieure de la cathode creuse étant reliée sur le plan de la technique des écoulements, avec l'intérieur du contenant (102) à traiter ainsi qu'avec la partie de la lance à gaz (101) amenant le gaz de processus, par des alésages ou évidements latéraux (113) et axiaux (114), et un plasma peut être produit à l'intérieur de la cathode creuse dans ladite au moins une cavité.

2. Dispositif selon la revendication 1, **caractérisé en ce que** la partie de la lance à gaz non réalisée sous forme de cathode creuse est pourvue d'alésages ou d'évidements, de préférence agencés latéralement ou axialement, par exemple avec des diamètres moyens d'alésage et/ou d'évidement <0,5 mm, de préférence de 0,1-0,2 mm, à travers lesquels du gaz de processus peut être amené à l'intérieur du contenant et/ou dans ladite au moins une cavité de la cathode creuse.

3. Dispositif selon la revendication 1 ou la revendication 2, **caractérisé en ce que** la lance à gaz (101) présente sur la totalité de sa longueur, par exemple de 50-500 mm, de préférence 200-300 mm, une cavité intérieure, par exemple avec un diamètre intérieur moyen de 2-20 mm, de préférence 6 mm, et la cavité intérieure présente des alésages et/ou des évidements, de préférence latéralement (113) et/ou axialement (114), par exemple avec des diamètres moyens d'alésage et/ou d'évidement >0,5 mm, de préférence de 1-2 mm.

4. Dispositif selon l'une des revendications précédentes 1 à 3, **caractérisé en ce que** la lance à gaz (101) est montée rotative.

5. Dispositif selon l'une des revendications précédentes 1 à 4, **caractérisé en ce que** la lance à gaz est réalisée de telle façon que du gaz de processus et du gaz inerte neutre, ne participant pas au revêtement, soient amenés de manière séparée spatialement, le gaz de processus étant amené directement au contenant, et le gaz inerte neutre, ne participant pas au revêtement, directement à la cathode creuse ou à la cavité intérieure.

6. Dispositif selon la revendication 5, **caractérisé en ce que** la lance à gaz (601) dispose d'une lance à gaz intérieure (621) par l'intermédiaire de laquelle du gaz inerte neutre (606), ne participant pas au revêtement, peut être amené dans la cavité intérieure de la cathode creuse (610) de la lance à gaz intérieure (621), et comporte également une lance à gaz extérieure (622) par l'intermédiaire de laquelle du gaz de processus (605) peut être amené à l'intérieur du contenant (602), grâce au fait que le gaz de processus (605) peut pénétrer dans l'intérieur du contenant en s'échappant d'alésages/d'évidements latéraux (613), par exemple avec des diamètres moyens d'alésage et/ou d'évidement <0,5 mm, de préférence de 0,1-0,2 mm, et/ou d'au moins un alésage axial, ou une ouverture de sortie axiale (620) de la lance à gaz intérieure (621).

7. Dispositif selon la revendication 6, **caractérisé en ce que** la lance à gaz extérieure (622) suit partiellement ou en totalité le contour de la lance à gaz intérieure (621).

8. Procédé pour assurer le revêtement d'un récipient ou contenant (102) à l'aide d'un plasma, qui comprend le fait que la transformation d'un gaz de processus est assistée partiellement ou pratiquement en totalité par un plasma de cathode creuse produit dans une lance à gaz (101) selon l'une des revendications précédentes.
